# EUROPEAN PATENT APPLICATION

(11) **EP 4 383 007 A1**
(43) Date of publication of application: **12.06.2024**
(21) Application number: 22853079.6
(22) Date of filing: 03.08.2022
(51) Int. Cl.: G03F 1/64, G03F 7/20

(54) **EXPOSURE PELLICLE FACILITATING ATOMSPHERIC PRESSURE ADJUSTMENT**

(30) Priority: 05.08.2021 JP 2021128949
(71) Applicant: SHIN-ETSU CHEMICAL CO., LTD., Tokyo 1000005 (JP)
(72) Inventor: KUBOTA, Yoshihiro, Annaka-shi, Gunma 379-0127 (JP); YANASE, Yu, Annaka-shi, Gunma 379-0127 (JP); TAKEUCHI, Ayano, Annaka-shi, Gunma 379-0127 (JP); NISHIMURA, Akinori, Annaka-shi, Gunma 379-0127 (JP)
(74) Representative: Meissner Bolte Partnerschaft mbB
(86) International application number: PCT/JP2022/029726
(87) International publication number: WO 2023/013660

(57) **Abstract**

[Object] To improve the performance of a filter for a vent hole, which penetrates a pellicle frame, in response to a reduction in the maximum allowable size of foreign matter, which is required especially in EUV exposure, and to a severe change in atmospheric pressure to which a pellicle film is to be exposed.

[Solution] A pellicle according to the present invention includes: a pellicle frame 3; a pellicle film 1 provided on an upper end surface of the pellicle frame; a vent hole 6 provided in the pellicle frame; and a filter 7 that closes the vent hole. The filter includes a non-woven fabric composed partly or entirely of at least one of nanofibers and carbon nanotubes.

## Description

### Technical Field

The present invention relates to a pellicle for exposure which protects an exposure mask, used in the manufacturing of a semiconductor device, a liquid crystal display, or the like, from foreign matter and which is capable of easy adjustment of atmospheric pressure, and more particularly to a pellicle for EUV masks which is capable of easy adjustment of atmospheric pressure.

### Background Art

In the manufacturing of a semiconductor device, a liquid crystal display, or the like, a circuit pattern is formed by a so-called lithography technique using an exposure mask (also referred to simply as a "mask"). In recent years, particularly in semiconductor devices, circuit patterns have become finer from micrometers to submicrometers and further to nanometers, and exposure light sources have changed accordingly to shorter-wavelength ones: g-line (436 nm), i-line (365 nm), KrF excimer laser (248 nm), and ArF excimer laser (193 nm). Even shorter-wavelength EUV (extreme ultraviolet, 13.5 nm) exposure has been studied these days, and has begun to be put into practice in some leading-edge devices.

Generally, in the manufacturing of a semiconductor device such as an LSI or a VLSI, after applying a resist to a wafer, the wafer, together with an exposure mask with a desired circuit pattern drawn thereon, is placed in an exposure machine, the exposure mask is irradiated by light, and the circuit pattern is transferred onto the wafer. These operations are usually performed in a clean room where the amount of dust has been reduced as much as possible. Nevertheless, dust from the human body, devices, or the environment often adheres to a mask upon its movement or setting after its production. Such dust is transferred together with a circuit pattern, and therefore an abnormal circuit will be formed. Thus, the resulting semiconductor device is a defective product, leading to a decrease in the manufacturing yield.

To avoid this problem, it is common practice to attach a dust-proof pellicle to a mask immediately after its production, as disclosed in Non-Patent Document 1. This is because once a pellicle is attached to a mask, dust approaching the mask is blocked by the pellicle and cannot reach a circuit pattern on the mask. Dust may land on a pellicle film. However, since the dust lies at a distance from the surface of the mask, by focusing an exposure beam on the circuit pattern, the dust on the pellicle will be "out of focus" and will not be transferred.

In general, a pellicle basically includes a metal frame, a pellicle film which is stretch-mounted on the upper end surface of the frame via an adhesive and which is highly transparent and resistant to light at an exposure wavelength, an agglutinant layer which is formed on the lower end surface of the frame, to be attached to a mask, and which is made of a relatively light-resistant resin such as an acrylic resin or a silicone resin, a vent hole, drilled in the frame, for adjusting the pressure difference between the inside and outside of the pellicle after it is hermetically mounted to a mask, and a filter which closes the outer opening of the vent hole.

The pellicle film may be made of a material which has a high permeability and a high resistance to light at an exposure wavelength. The material may be, for example, nitrocellulose for g-line (436 nm), cellulose propionate for i-line (365 nm), or an amorphous fluoropolymer for KrF excimer laser (248 nm) or ArF excimer laser (193 nm). With the progress toward finer circuits, the wavelength of exposure light is becoming increasingly shorter, and EUV (extreme ultraviolet, 13.5 nm) exposure has begun to be used recently. While any material that is highly permeable and highly resistant to EUV light can be used for a pellicle film for EUV exposure, it is practically preferred to use monocrystalline silicon, polycrystalline silicon, or amorphous silicon, or a nitride, oxynitride or carbide thereof, because it can form a uniform film at low cost with good reproducibility. In order to protect such a film material, the pellicle film may be provided with a protective film made of, for example, SiC, SiO₂, Si₃N₄, SiON, Y₂O₃, YN, Mo, Ru, or Rh. Films of such an inorganic material, which has a submicron or smaller thickness to achieve a high permeability, have been studied, and some of them have already been put into practical use.

In conventional pellicles for g-line (436 nm), i-line (365 nm), KrF excimer laser (248 nm), ArF excimer laser (193 nm), or the like, which are used under atmospheric pressure, a non-woven fabric of PET, PTFE, or the like, having a fiber diameter of a few tens of micrometers to several hundred micrometers, is generally used as a filter for a vent hole (Patent Document 1).

### Citation List

### Patent Document

Patent Document 1: Japanese Patent Laid-Open Publication No. 2005-268464

### Non-Patent Document

Non-Patent Document 1: "Electronic Materials", July 1997 issue, p. 103

### Summary of Invention

### Technical Problem

On the other hand, in the case of pellicles for EUV (extreme ultraviolet: 13.5 nm) exposure that has begun to be actually used recently, which are used under vacuum or reduced pressure, a conventional filter made of a resin such as PET or PTFE, or a porous sintered metal or ceramic is used or proposed as a filter for a vent hole in some pellicles. However, in the present situation, there is almost no filter that can withstand the severe conditions of use, which is a major obstacle to practical use of EUV (extreme ultraviolet: 13.5 nm) exposure. In particular, conventional non-woven fabric filters, made of a resin such as PET or PTFE, have a large fiber diameter and entail a high pressure loss, and have the drawback that they permit easy passage therethrough of submicron or smaller dust to be blocked. In the case of a filter made of a porous sintered metal or ceramic, it is technically difficult to make its filtration pores fine and uniform because fusion between pores is likely to occur during the production of the filter. Thus, pores larger than the diameter of dust to be blocked, pores smaller than necessary, closed pores, etc. may be co-present in such a filter, causing problems such as a high pressure loss during ventilation and unstable filter performance.

On the other hand, an EUV exposure apparatus is hugely expensive, costing tens of billions of yen. In addition, vacuuming and returning to atmospheric pressure upon carrying-in/carrying-out of a mask, which are of no direct use to production, but are essential for the operation of the exposure apparatus, constitute a dead time in the operation of the apparatus and cause an increase in cost. Therefore, in order to reduce the production cost, the vacuuming and returning to atmospheric pressure are required to be performed at a higher speed so as to increase the operating rate of the EUV exposure apparatus even if only a little.

However, ultra-thin rigid films having a submicron or smaller thickness, made of an inorganic material such as monocrystalline silicon, polycrystalline silicon, or amorphous silicon, or a nitride, oxynitride or carbide thereof, are commonly used as current pellicle films for EUV exposure from the viewpoint of resistance and permeability to EUV light and from the viewpoint of processability. When the above-described vacuuming and returning to atmospheric pressure are performed at a high speed, rapid inflow or outflow of air produces local air-concentration differences in the space confined by a mask and a pellicle, which have been integrated, thereby producing large local pressure differences between the inside and outside of the pellicle. An ultra-thin rigid pellicle film cannot follow such pressure differences; the pellicle film will be broken and scatter, contaminating the interior of an expensive exposure machine. This makes it impossible to perform subsequent exposure operations, thus causing enormous loss. This problem is a big bottleneck in the EUV exposure technology.

To address the problem, prior art, for example Patent Document 1, proposes covering a circuit pattern with a mask cover (reticle cover) that serves both as a so-called pellicle film and as a vent filter to protect the circuit pattern from dust. This method allows for an extremely large filter area, including an exposure surface, thereby enabling high-speed vacuuming and returning to atmospheric pressure. On the other hand, this method has the following serious problem. The document describes the use of a porous fluororesin, in particular a PTFE, to secure vent holes for the filter. Such an organic material, however, will be decomposed in a short period of time when it is irradiated by EUV light which is ultraviolet light having an extremely short wavelength (extreme ultraviolet: 13.5 nm) and has a very large irradiation energy. Even a PTFE, which has a relatively good light resistance, cannot withstand long-term use with EUV light.

### Solution to Problem

The present inventors have made intensive efforts to solve the above-described bottleneck and various problems, resulting in completion of the present invention. Thus, the present invention can be embodied as follows.
[1] A pellicle comprising:
   a pellicle frame;
   a pellicle film provided on an upper end surface of the pellicle frame;
   a vent hole provided in the pellicle frame; and
   a filter that closes the vent hole,
   wherein the filter includes a sheet composed partly or entirely of at least one of nanofibers and carbon nanotubes.
[2] A pellicle comprising:
   a pellicle frame;
   a pellicle film provided on an upper end surface of the pellicle frame;
   a vent hole provided in the pellicle frame; and
   a filter that closes the vent hole,
   wherein the filter includes a non-woven fabric composed partly or entirely of at least one of nanofibers and carbon nanotubes.
[3] The pellicle as set forth in [2] above, wherein the filter includes a non-woven fabric composed partly or entirely of nanofibers and carbon nanotubes.
[4] The pellicle as set forth in any one of [1] to [3] above, wherein 5 to 70 vol % of the fibers constituting the filter are fibers having an average fiber diameter of a few micrometers to several hundred micrometers.
[5] The pellicle as set forth in any one of [1] to [4] above, wherein the filter is partly or entirely inserted into the vent hole.
[6] The pellicle as set forth in any one of [1] to [5] above, wherein a counterbore is provided at an outer opening of the vent hole, and the filter is partly or entirely embedded in the counterbore.
[7] The pellicle as set forth in any one of [1] to [6] above, wherein at least one of an outer opening and an inner opening of the vent hole is chamfered.
[8] The pellicle as set forth in any one of [1] to [7] above, wherein a proportion of a total opening area of the vent hole to a total area of a lower end surface of the pellicle frame is 2% or more.
[9] The pellicle as set forth in [8] above, wherein the proportion of the total opening area of the vent hole to the total area of the lower end surface of the pellicle frame is 10% or more and 50% or less.
[10] The pellicle as set forth in any one of [1] to [9] above, wherein the filter has a filtration accuracy gradient in which the average fiber diameter gradually decreases in a direction from one surface toward an opposite surface or in a direction from both surfaces toward a central plane.
   The term "filtration accuracy gradient" herein refers to a gradual change in the filtration accuracy of a filter material. Generally, the filter is configured to capture particles in order of gradually decreasing diameter to prevent rapid clogging of the filter.
[11] The pellicle as set forth in any one of [1] to [10] above, wherein the filter includes fibers having an average fiber diameter of a few micrometers to several hundred micrometers, and a presence proportion of the fibers gradually decreases in a direction from one surface toward an opposite surface or in a direction from both surfaces toward a central plane.
[12] The pellicle as set forth in [10] or [11] above, wherein the filter includes a plurality of non-woven fabric sheets that are integrally stacked and have different average fiber diameters.
[13] The pellicle as set forth in any one of [1] to [12] above, wherein the pellicle film has a thickness of 1 um or less, and is partly or entirely made of monocrystalline silicon, polycrystalline silicon, or amorphous silicon, or a nitride, oxynitride or carbide thereof.
[14] The pellicle as set forth in any one of [1] to [13] above, wherein the pellicle film has a coating of an inorganic compound.
[15] The pellicle as set forth in [14] above, wherein the inorganic compound is SiC, Si₃N₄, or Y₂O₃.
[16] The pellicle as set forth in any one of [1] to [15] above, wherein the surfaces of the nanofibers are partly or entirely coated with SiC or Si₃N₄.
[17] The pellicle as set forth in any one of [1] to [16] above, wherein the pellicle is a pellicle for EUV masks.
[18] A pellicle frame with a filter, comprising:
   a pellicle frame;
   a vent hole provided in the pellicle frame; and
   a filter that closes the vent hole,
   wherein the filter includes a sheet composed partly or entirely of at least one of nanofibers and carbon nanotubes.
[19] A pellicle frame with a filter, comprising:
   a pellicle frame;
   a vent hole provided in the pellicle frame; and
   a filter that closes the vent hole,
   wherein the filter includes a non-woven fabric composed partly or entirely of at least one of nanofibers and carbon nanotubes.
[20] An exposure mask with a pellicle, comprising an exposure mask, and the pellicle as set forth in any one of [1] to [17] above, mounted on the exposure mask.
[21] A method for producing the pellicle as set forth in any one of [1] to [17] above, comprising a step of producing the nanofibers using an electrospinning method.
[22] An exposure method comprising performing exposure using the exposure mask with a pellicle as set forth in [20] above.
[23] A method for manufacturing a semiconductor device, comprising a step of performing exposure using the exposure mask with a pellicle as set forth in [20] above.

### Advantageous Effects of Invention

According to the present invention, let alone being capable of performing actions of various ordinary pellicles, it is possible to perform vacuuming and returning to atmospheric pressure at a higher speed when carrying a mask into/out of a leading-edge EUV exposure machine which performs transfer of ultrafine patterns. This makes it possible to increase the operating rate of the expensive exposure apparatus and significantly reduce the production cost.

### Brief Description of Drawings

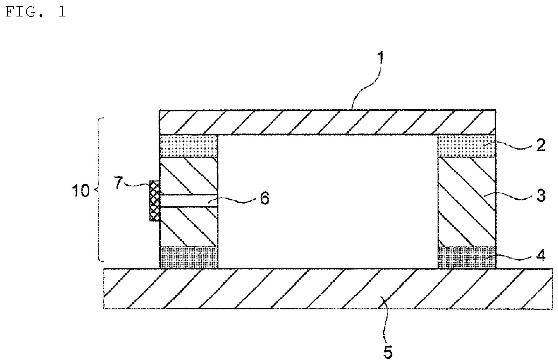

FIG. 1 is a schematic diagram showing a vertical sectional structure of an exposure mask with a pellicle according to an embodiment of the present invention.

### Description of Embodiments

Embodiments of the present invention will now be described in detail with reference to the drawings.

As shown in FIG. 1, the pellicle 10 of the present invention includes a pellicle frame 3, an ultra-thin pellicle film 1 provided on the upper end surface of the pellicle frame 3 via an adhesive layer 2, and at least one vent hole 6 provided in the pellicle frame 3. The vent hole(s) is closed by a filter 7 for preventing entry of foreign matter, comprising a non-woven fabric composed partly or entirely of at least one of nanofibers and carbon nanotubes (CNTs). In FIG. 1, the filter 7 is located outside the outer opening of the vent hole 6. However, in one embodiment, the filter 7 may be partly or entirely inserted into the vent hole 6. The outer opening of the vent hole 6 may be provided with a counterbore in which the filter 7 is partly or entirely embedded. In order to reduce the generation of dust from a peripheral portion of the pellicle frame 3 and to prevent the generation of dust upon contact between the filter 7 and a peripheral portion around the vent hole 6, at least one of the outer opening and inner opening of the vent hole 6 may be chamfered. The pellicle frame 3 has a frame-like shape (usually square) corresponding to the shape of a mask 5.

The above-described non-woven fabric refers to "a fiber sheet, web or batt, in which the fibers are oriented in one direction or randomly, and are bound by interlacing and/or fusion and/or adhesion, excluding paper, a woven fabric, a knitted fabric, a tuft, and a fulled felt.", as described in JIS L-0222:2001. In the present invention, the filter need not necessarily be a non-woven fabric; it suffices if the filter is a sheet. It is preferred that the sheet be partly or entirely composed of at least one of nanofibers and carbon nanotubes (CNTs) in a sheet form, and that the nanofibers or the carbon nanotubes (CNTs) be entangled.

The pellicle film 1 is an ultra-thin film made of silicon, in particular monocrystalline silicon, polycrystalline silicon, or amorphous silicon, or a nitride, oxynitride or carbide thereof. Such a silicon material is selected, for example because compared to various metals and inorganic compounds, thin films of the various crystal forms or of the various silicon compounds are relatively strong, and a high-purity film can be produced easily and economically. A carbon film made of graphene, diamond-like carbon, carbon nanotubes, or the like is also effective for EUV exposure. To prevent cracking and corrosion, the pellicle film 1 preferably has a coating of an inorganic compound such as SiC, Si₃N₄, or Y₂O₃. When it is difficult to handle the pellicle film alone, the pellicle film supported by a frame, e.g. made of silicon, can be used. In that case, the pellicle can be easily produced by bonding an area of that frame and the pellicle frame.

If the thickness of the pellicle film 1 exceeds 1 µm, the amount of transmitted exposure light will be insufficient. Therefore, the film thickness is preferably 1 um or less, more preferably 100 nm to 1 µm.

As described above, in the present invention, the vent hole 6 provided in the pellicle frame is closed by the filter 7 for preventing entry of foreign matter, comprising a non-woven fabric composed partly or entirely of at least one of nanofibers and carbon nanotubes (including the case of both of nanofibers and carbon nanotubes). As described previously, conventional non-woven fabric filters are no longer able to remove foreign matter such as dust, which is problematic for recent highly fine, ultra-high definition circuit patterns of the order of submicrons to several nanometers. On the other hand, in the case of porous sintered metal or ceramic filters, it is difficult to adjust the pore size distribution, the degree of closing of pores, or the thickness during firing of the filter material, causing problems such as high pressure loss and poor reproducibility. There is no particular limitation on the location, number and shape of the vent hole(s); they may take a variety of forms.

The vent hole(s) is preferably provided such that it connects the space outside the pellicle and the space inside the pellicle. The vent hole(s) which penetrates the pellicle frame, extending from the outer surface to the inner surface as shown in FIG. 1, is easy to produce. Instead of such a vent hole(s) extending between the outer and inner surfaces of the pellicle frame, it is possible to provide a vent hole(s) which extends from the outer surface of the pellicle frame toward the inner surface, and halfway turns in a direction toward the upper end surface or lower end surface of the pellicle frame, and opens to the upper end surface or lower end surface of the pellicle frame. Alternatively, a vent hole(s) may be provided which extends from the inner surface of the pellicle frame toward the outer surface, and halfway turns in a direction toward the upper end surface or lower end surface of the pellicle frame, and opens to the upper end surface or lower end surface of the pellicle frame. Such a vent hole(s), which changes its direction halfway, enables easy design of a large opening area at the upper end surface or lower end surface of the pellicle frame, and therefore is useful for a thin pellicle such as a pellicle for EUV exposure whose height is limited to about 2.5 mm or less.

The above-described problems can be solved by closing the vent hole(s) 6 with the filter 7 for preventing entry of foreign matter, comprising a non-woven fabric composed partly or entirely of at least one of nanofibers and carbon nanotubes, according to the present invention. Therefore, the pellicle of the present invention can be advantageously used, let alone as a pellicle for conventional use, also as a pellicle for a leading-edge ultrafine mask, especially a pellicle for an EUV mask. In particular, foreign matter of the order of submicrons to several nanometers can be captured with high efficiency by the filter employed in the present invention; therefore, the filter can be made thinner. In addition, because of the ultrafine fibers, the pressure loss upon inflow/outflow of air or a gas can be reduced. Such a synergistic effect makes it possible to perform vacuuming and returning to atmospheric pressure at a higher speed upon carrying-in/carrying-out of a mask. It therefore becomes possible to reduce the dead time in the operation of an exposure apparatus, thereby increasing the operating rate of the exposure apparatus and reducing the production cost.

When one of the openings of the vent hole 6 is provided in the upper end surface or lower end surface of the pellicle frame, the total opening area of the vent hole(s) 6 is preferably 2% or more of the total area of the end surface, having the opening(s), of the pellicle frame, and is more preferably 10% or more in order to enable higher-speed vacuuming and returning to atmospheric pressure and to thereby enable a further reduction in the production cost. The upper limit of the total opening area of the vent hole(s) depends on the strength of the pellicle frame. If the total opening area is too large, the pellicle frame will be deformed, and therefore a circuit pattern will be distorted undesirably. While the upper limit of the total opening area should preferably be determined depending on the type of the pellicle frame, due to the difficulty of processing a high-strength pellicle frame, if the total opening area exceeds 50%, it is likely to lose its rationality to support increased processing cost for any type of pellicle frame. Therefore, the total opening area is preferably 50% or less, more preferably 45% or less, and particularly preferably 35% or less. As used herein, the total opening area refers to the proportion of the total area of an opening(s) provided in an end surface of the pellicle frame to the total area of the end surface having the opening(s).

Fibers produced by a drawing method are generally used in a common non-woven fabric production method. The average fiber diameter of such fibers is as large as several micrometers or more. Further, the diameters of the fibers may vary greatly depending on the drawing force applied; the fibers may have a wide diameter distribution. Accordingly, the foreign matter capture rate and the strength of the resulting non-woven fabric may not be constant. Such fibers are therefore unsuitable and cannot be used as nanofibers in the present invention. In the present invention, nanofibers produced by a so-called electrospinning method, which provide a non-woven fabric having relatively constant strength and foreign matter capture rate, can be optimally used. Further, a non-woven fabric, produced by the electrospinning method and/or a well-known CNT production method, can be optimally used. As is well known, the electrospinning method comprises pouring a polymer solution, which is the raw material for nanofibers, into a syringe, applying a high voltage to the polymer solution to charge it, and causing an electrostatic explosion to produce nanofibers. Conditions for performing the method are not particularly limited, and may be appropriately set depending on the type of the polymer material, etc.

There is no particular limitation on the material of the nanofibers. Examples of the material include organic polymers (polypropylene, polyester, polycarbosilane, polyethylene, nylon, polyacetate, polyacrylate, polystyrene, polyvinyl chloride, etc.), inorganic polymers (silica, alumina, titania, zirconia, etc.), natural polymers (cellulose, chitin, etc.), and carbon materials. As used herein, "nanofibers" refer to a fibrous material having an average fiber diameter of the order of nanometers.

In the present invention, there is no particular limitation on the average fiber diameter of nanofibers and carbon nanotubes; however, it is generally 1 um or less, and preferably in the range of 10 to 950 nm. This is because fibers having an average diameter of less than 10 nm have a too-low strength, and therefore are difficult to handle. On the other hand, it is difficult for fibers having an average diameter of more than 950 nm to remove foreign matter of the order of nanometers, which has recently become a problem.

In the present invention, rather than solely using nanofibers and/or carbon nanotubes for the filter, it is preferred to intentionally add thereto fibers having a diameter of a few micrometers to several hundred micrometers (e.g., about 1 um to 300 µm) in an amount of 5 to 70 vol % of the fibers constituting the filter in order to increase the strength of the filter so that it will withstand wind pressure upon vacuuming and returning to atmospheric pressure at a high speed. If the amount of the fibers having a diameter of a few micrometers to several hundred micrometers is less than 5 vol %, the strength of the filter is not so high as to be able to achieve a considerable speed-up of vacuuming and returning to atmospheric pressure. On the other hand, if the amount is more than 70 vol %, the rate of capture of fine foreign matter having a submicron or smaller size will begin to decrease, though the strength of the filter is high.

In the present invention, nanofibers, in particular inorganic nanofibers such as silica nanofibers or CNTs, have a brittle and active surface, and are therefore easily lost or damaged depending on the ambient gas. Therefore, the surfaces of such nanofibers may be modified to some extent by coating them with SiC, Si₃N₄, or the like.

In the present invention, the filter preferably has a filtration accuracy gradient in which the average fiber diameter gradually decreases in a direction from one surface toward an opposite surface or in a direction from both surfaces toward a central plane. The formation of such a filtration accuracy gradient can increase the strength of the filter, increase the foreign matter capture rate, and reduce the pressure loss. This enables higher-speed vacuuming and returning to atmospheric pressure upon carrying-in/carrying-out of a mask. In a more preferred embodiment, the non-woven fabric of the filter has a filtration accuracy gradient in which the mixing ratio between nanofibers and thick fibers having a diameter of a few micrometers to several hundred micrometers gradually changes such that the average fiber diameter gradually decreases in a direction from one surface toward an opposite surface or in a direction from both surfaces toward a central plane. It is to be noted in this regard that while a non-woven fabric composed solely of nanofibers has a high foreign matter capture rate, it has a low filter strength; it may break easily and thus may not withstand long-term use.

When nanofibers are mixed with the thick fibers having a diameter of a few micrometers to several hundred micrometers, the thick fibers are preferably polymer fibers having a bending strength and flexibility, such as polypropylene, polyester or polycarbosilane fibers. This is because such polymer fibers act like reinforcing bars in reinforced concrete, and can prevent the coexisting nanofibers and the entire filter from being destroyed by wind pressure upon high-speed vacuuming or returning to atmospheric pressure.

A method for producing the filter with a gradual filtration accuracy gradient comprises appropriately selecting a plurality of non-woven fabric sheets, composed of fibers having different average fiber diameters, so that a desired gradient will be achieved, and integrally stacking the sheets. After the stacking, an adhesive may be applied to the side surfaces of the stack to prevent scattering of fibers. When the filter is embedded in a counterbore, it is preferred to apply an adhesive to the side surface of the counterbore.

The filter thus produced is mounted to the pellicle frame such that the filter closes a vent hole drilled in the pellicle frame. The mounting of the filter can be performed in the same manner as for conventional filters. For example, an adhesive is applied, e.g. in a rectangular frame-like shape or a ring shape according to the shape of the filter, to an area around the outer opening of the vent hole, and the filter is attached to the adhesive. When there is a counterbore, the adhesive may be applied to the side surface of the counterbore so as to fix the filter and prevent scattering of fibers of the filter.

A method for mounting the pellicle of the present invention to a mask will be described using FIG. 1. An agglutinant layer 4 for mounting the pellicle 10 to the photomask 5 is formed on the lower end surface of the pellicle frame 3. A liner (not shown) for protecting the surface of the agglutinant is provided on the lower end surface of the agglutinant layer 4. When mounting the pellicle 10 to the photomask 5, the liner is detached to expose the agglutinant layer 4, and it is attached to the photomask 5.

### Examples

The following examples and comparative examples illustrate the present invention in greater detail and are not intended to limit the scope of the invention.

### [Example 1]

28 non-woven fabric filters having a thickness of 500 um were produced. Each filter was produced using a mixture of polypropylene fibers having an average fiber diameter of 5 µm, which are used in current filters, and silica nanofibers having an average fiber diameter of 0.3 um and produced by an electrospinning method. The filters had a "filtration accuracy gradient" in which the average fiber diameter at both end surfaces was 0.95 um, and the average fiber diameter in the central area was 0.35 um. The average fiber diameter was calculated from an SEM image.

Next, as shown in FIG. 1, a total of 28 vent holes 6 (total opening area = 450 mm², 21% of the total area of the lower end surface of a pellicle frame) of a pellicle frame 3, over which a p-Si (polysilicon) pellicle film 1 having a thickness of 0.1 um was stretched, were each closed by each of the above non-woven fabric filters 7. The pellicle 10 was then attached to an exposure mask 5 via an agglutinant layer 4.

Thereafter, the exposure mask was mounted in a simulated EUV apparatus. NaCl was treated in an atomizer to generate fine NaCl particles, and the particles were subjected to classification using an electrostatic classifier to obtain fine NaCl particles having a size of 0.01 to 0.5 um, which were used as a pseudo-foreign matter atmosphere. While introducing the pseudo-foreign matter atmosphere into the simulated EUV apparatus, a simulation of vacuuming and returning to atmospheric pressure, assuming operations upon carrying-in/carrying-out of a mask, was performed. After vacuuming, the foreign matter capture rate and the differential pressure upon returning to atmospheric pressure were measured for a rough evaluation of the non-woven fabric filters.

As a result, the foreign matter capture rate was 100% for all the fine particles having a size of 0.01 to 0.5 um. The differential pressure was 0.5 Pa at a linear velocity of 0.15 cm/s. The p-Si pellicle film could sufficiently withstand the shock caused by pressure change without being damaged.

### [Comparative Example 1]

28 non-woven fabric filters having a thickness of 500 um as comparative current filters were produced. Each filter was composed solely of the same polypropylene fibers having an average fiber diameter of 5 um as used in Example 1, and was uniform in the thickness direction with no filtration accuracy gradient over the entire thickness.

Thereafter, the non-woven fabric filters were used as the filter for the same pellicle frame with the same apparatus and under the same conditions as in Example 1. After vacuuming, the foreign matter capture rate and the differential pressure upon returning to atmospheric pressure were measured for an evaluation of the non-woven fabric filters.

As a result, the foreign matter capture rate was 94.0% for fine particles having a size of around 0.01 um, 93.5% for fine particles having a size of around 0.05 um, 94.8% for fine particles having a size of around 0.10 um, and 95.3% for fine particles having a size of around 0.5 um. The differential pressure was 20.5 Pa at a linear velocity of 0.15 cm/s. Because of the too-high differential pressure, the ultra-thin p-Si pellicle film ruptured during returning to atmospheric pressure. This indicates that the current filters are unsuitable for the simulated EUV apparatus.

### [Example 2]

28 non-woven fabric filters, each having a filtration accuracy gradient in an intermediate portion, were produced. Each filter was produced in the following manner. Polyester fibers having an average fiber diameter of 3 um were piled up to 50 um to form one end surface. A mixture of carbon nanotubes (CNTs) having an average fiber diameter of 35 nm (0.035 um) and the same polyester fibers having an average fiber diameter of 3 um was piled on the one end surface up to 400 um while gradually changing the mixing ratio between the both fibers. Further, the same CNTs having an average fiber diameter of 35 nm was piled up to 50 um to form the opposite end surface, thereby completing the non-woven fabric filter. Next, as shown in FIG. 1, a total of 28 vent holes 6 (total opening area = 321 mm², corresponding to 15% of the total area of the lower end surface of a pellicle frame) of a pellicle frame 3, over which a p-Si pellicle film 1 having a thickness of 0.1 um was stretched, were closed by the above non-woven fabric filters. The pellicle 10 was then attached to an exposure mask 5 via an agglutinant layer 4.

The pellicle 10 was subjected to the same simulation using the same apparatus and the same conditions as in Example 1, and the non-woven fabric filters were evaluated in the same manner as in Example 1.

As a result, the foreign matter capture rate was 100% for all the fine particles having a size of 0.01 to 0.5 um. The differential pressure was 0.2 Pa at a linear velocity of 0.15 cm/s. The p-Si pellicle film was not damaged by the differential pressure, and could sufficiently withstand the vacuuming and returning to atmospheric pressure upon carrying-in/carrying-out of the exposure mask.

### Description of Reference Symbols

1 pellicle film
2 adhesive layer
3 pellicle frame
4 agglutinant layer
5 photomask
6 vent hole
7 filter
10 pellicle

## Claims

1. A pellicle comprising:
a pellicle frame;
a pellicle film provided on an upper end surface of the pellicle frame;
a vent hole provided in the pellicle frame; and
a filter that closes the vent hole,
wherein the filter includes a sheet composed partly or entirely of at least one of nanofibers and carbon nanotubes.

2. A pellicle comprising:
a pellicle frame;
a pellicle film provided on an upper end surface of the pellicle frame;
a vent hole provided in the pellicle frame; and
a filter that closes the vent hole,
wherein the filter includes a non-woven fabric composed partly or entirely of at least one of nanofibers and carbon nanotubes.

3. The pellicle according to claim 2, wherein the filter includes a non-woven fabric composed partly or entirely of nanofibers and carbon nanotubes.

4. The pellicle according to any one of claims 1 to 3, wherein 5 to 70 vol % of the fibers constituting the filter are fibers having an average fiber diameter of a few micrometers to several hundred micrometers.

5. The pellicle according to any one of claims 1 to 4, wherein the filter is partly or entirely inserted into the vent hole.

6. The pellicle according to any one of claims 1 to 5, wherein a counterbore is provided at an outer opening of the vent hole, and the filter is partly or entirely embedded in the counterbore.

7. The pellicle according to any one of claims 1 to 6, wherein at least one of an outer opening and an inner opening of the vent hole is chamfered.

8. The pellicle according to any one of claims 1 to 7, wherein a proportion of a total opening area of the vent hole to a total area of a lower end surface of the pellicle frame is 2% or more.

9. The pellicle according to claim 8, wherein the proportion of the total opening area of the vent hole to the total area of the lower end surface of the pellicle frame is 10% or more and 50% or less.

10. The pellicle according to any one of claims 1 to 9, wherein the filter has a filtration accuracy gradient in which the average fiber diameter gradually decreases in a direction from one surface toward an opposite surface or in a direction from both surfaces toward a central plane.

11. The pellicle according to any one of claims 1 to 10, wherein the filter includes fibers having an average fiber diameter of a few micrometers to several hundred micrometers, and a presence proportion of the fibers gradually decreases in a direction from one surface toward an opposite surface or in a direction from both surfaces toward a central plane.

12. The pellicle according to claim 10 or 11, wherein the filter includes a plurality of non-woven fabric sheets that are integrally stacked and have different average fiber diameters.

13. The pellicle according to any one of claims 1 to 12, wherein the pellicle film has a thickness of 1 um or less, and is partly or entirely made of monocrystalline silicon, polycrystalline silicon, or amorphous silicon, or a nitride, oxynitride or carbide thereof.

14. The pellicle according to any one of claims 1 to 13, wherein the pellicle film has a coating of an inorganic compound.

15. The pellicle according to claim 14, wherein the inorganic compound is SiC, Si₃N₄, or Y₂O₃.

16. The pellicle according to any one of claims 1 to 15, wherein surfaces of the nanofibers are partly or entirely coated with SiC or Si₃N₄.

17. The pellicle according to any one of claims 1 to 16, wherein the pellicle is a pellicle for EUV masks.

18. A pellicle frame with a filter, comprising:
a pellicle frame;
a vent hole provided in the pellicle frame; and
a filter that closes the vent hole,
wherein the filter includes a sheet composed partly or entirely of at least one of nanofibers and carbon nanotubes.

19. A pellicle frame with a filter, comprising:
a pellicle frame;
a vent hole provided in the pellicle frame; and
a filter that closes the vent hole,
wherein the filter includes a non-woven fabric composed partly or entirely of at least one of nanofibers and carbon nanotubes.

20. An exposure mask with a pellicle, comprising an exposure mask, and the pellicle according to any one of claims 1 to 17, mounted on the exposure mask.

21. A method for producing the pellicle according to any one of claims 1 to 17, comprising a step of producing the nanofibers using an electrospinning method.

22. An exposure method comprising performing exposure using the exposure mask with a pellicle according to claim 20.

23. A method for manufacturing a semiconductor device, comprising a step of performing exposure using the exposure mask with a pellicle according to claim 20.
